# EUROPEAN PATENT APPLICATION

(11) **EP 2 793 259 A2**
(43) Date of publication of application: **22.10.2014**
(21) Application number: 13185540.5
(22) Date of filing: 23.09.2013
(51) Int. Cl.: H01L 23/427

(54) **Phase transfer heat dissipating device and phase transfer heat dissipating system**

(30) Priority: 19.04.2013 TW 102114026
(71) Applicant: MicroThermal Technology Corp., Kwai Shan (TW)
(72) Inventor: Meng, Hsien-Chun, Kwai Shan (TW); Ku, Chih-Chiang, Kwai Shan (TW); Liao, Che-Wei, Kwai Shan (TW); Tsai, Wen-Kai, Kwai Shan (TW)
(74) Representative: Viering, Jentschura & Partner Patent- und Rechtsanwälte

(57) **Abstract**

A volumetric phase transfer heat dissipating device (1) includes a base (11), a cap (12) and an atomizing member (15). The base (11) includes a plurality of conducting members (112). The cap (12) is engaged with the base (11) to form a chamber (10). The conducting members (112) are disposed in the chamber (10) and extended toward the cap (12). The cap (12) includes an inlet connecting portion (124) for being connected to a fluid transmission tube (53) and includes an outlet connecting portion (125) for being connected to a vapor transmission tube (54). The atomizing member (15) is sleeved to the inlet connecting portion (124) and disposed between the fluid transmission tube (53) and the chamber (10). A working fluid (6) in the fluid transmission tube (53) flows into the chamber (10) via the atomizing member (15) and forms liquid on inner walls of the chamber (10) and outer walls of the conducting members (112), and the liquid is vaporized after absorbing heat and flows out via the vapor transmission tube (54).

## Description

### BACKGROUND

### Technical Field

The present invention relates to a heat dissipating device, and particularly relates to a volumetric phase transfer heat dissipating device.

### Related Art

In general, the heat flux per unit area (W/cm²) of conventional heat dissipating systems for active electronic components, such as a fan with cooling fins or a fan with cooling fins and heat pipes, fails to meet the heat dissipation requirements of high efficiency electronic components.

In order to meet the heat dissipation requirements of high efficiency electronic components, in recent years, technologies for cooling electronic components using the phase transfer principle have been developed. For example, U.S. Pat. No. 7,082,778 B2 patent discloses a spray cooling module functioned similar to the inkjet. In the spray cooling module, heating electrode plates are cooperated with the surface tension of the working liquid to generate bubbles, so that the working liquid is squeezed to form moistures in the spraying chamber, and the moisture is then thermally contacted with the electronic components so as to vaporize them, absorbing heat from the electronic components, and thus cooling them. However, the structure of the spray cooling module is too complicated to manufacture easily; additionally, since the electrode plates must be heated, when the working liquid is flowing to the electrode plates, the temperature of the working liquid increases, reducing heat dissipating efficiency. Therefore, it is necessary to develop another cooling system having high heat dissipating efficiency.

### SUMMARY

In view of this, the present invention proposes a volumetric phase transfer heat dissipating device which can atomize the working fluid efficiently, so as to vaporize the working fluid. The present invention has advantages such as a simplified structure, high heat dissipating performance, etc.

One invention concept of the present invention proposes a volumetric phase transfer heat dissipating device, including a base, a cap and an atomizing member. The base includes a plurality of conducting members. The cap is engaged with the base so as to form a chamber with the base. The conducting members are disposed in the chamber and are extended toward the cap. The cap includes an inlet connecting portion for being connected to a fluid transmission tube and includes an outlet connecting portion for being connected to a vapor transmission tube. The atomizing member is sleeved to the inlet connecting portion and is disposed between the fluid transmission tube and the chamber. A working fluid in the fluid transmission tube flows into the chamber via the atomizing member and forms liquid on inner walls of the chamber and outer walls of the conducting members, and the liquid is vaporized after absorbing heat and flowing out via the vapor transmission tube.

One invention concept of the present invention proposes a volumetric phase transfer heat dissipating system, including a condenser and a phase transfer heat dissipating device as mentioned above. The condenser includes a condenser body, a fluid transmission tube and a vapor transmission tube. One end of the fluid transmission tube and one end of the vapor transmission tube are connected to the condenser body. The fluid transmission tube is connected to the inlet connecting portion of the phase transfer heat dissipating device. The vapor transmission tube is connected to the outlet connecting portion of the phase transfer heat dissipating device. The working fluid in the fluid transmission tube is flowing into the chamber via the atomizing member and forms liquid on the inner walls of the chamber. The liquid is vaporized after absorbing heat and flows to the condenser body via the vapor transmission tube.

According to the present invention, the atomizing member is disposed in the inlet connecting portion of the cap, so that the working fluid is flowing into the chamber to form the liquid. Further, the liquid is disposed on the inner walls of the chamber and the outer walls of the conducting members and provided for heat absorption. The conducting members are disposed in the chamber so as to increase the contact area between the conducting members and the liquid to enhance the heat dissipating performance.

The detailed features and advantages of the present invention are described below in great detail through the following embodiments, the content of the detailed description is sufficient for those skilled in the art to understand the technical content of the present invention and to implement the present invention there accordingly. Based on the content of the specification, the claims, and the drawings, those skilled in the art can easily understand the relevant objectives and advantages of the present invention.

### BRIEF DESCRIPTION OF THE DRAWINGS

The present invention will become more fully understood from the detailed description given herein below for illustration only, and thus not limitative of the present invention, wherein:
FIG. 1 is a constructional schematic view of a volumetric phase transfer heat dissipating system of a first embodiment of the present invention;
FIG. 2 is a perspective view of the volumetric phase transfer heat dissipating system of the first embodiment of the present invention;
FIG. 3 is a partial exploded view of the phase transfer heat dissipating system of the first embodiment of the present invention;
FIG. 4 is a partial lateral view of the volumetric phase transfer heat dissipating system of the first embodiment of the present invention; and
FIG. 5 is a partial enlarged view of the volumetric phase transfer heat dissipating system of the first embodiment of the present invention.

### DETAILED DESCRIPTION

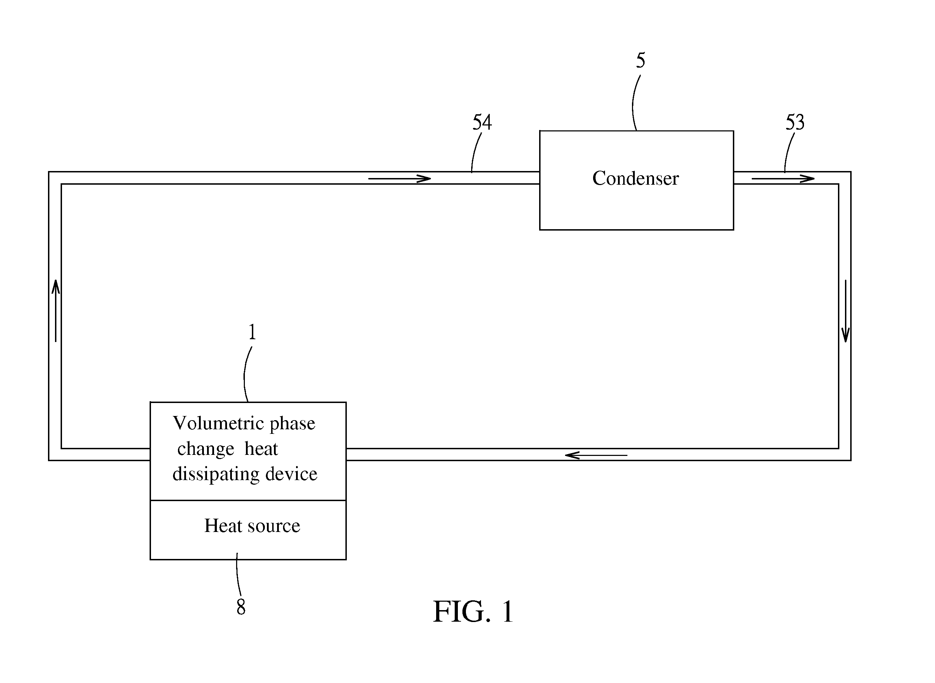

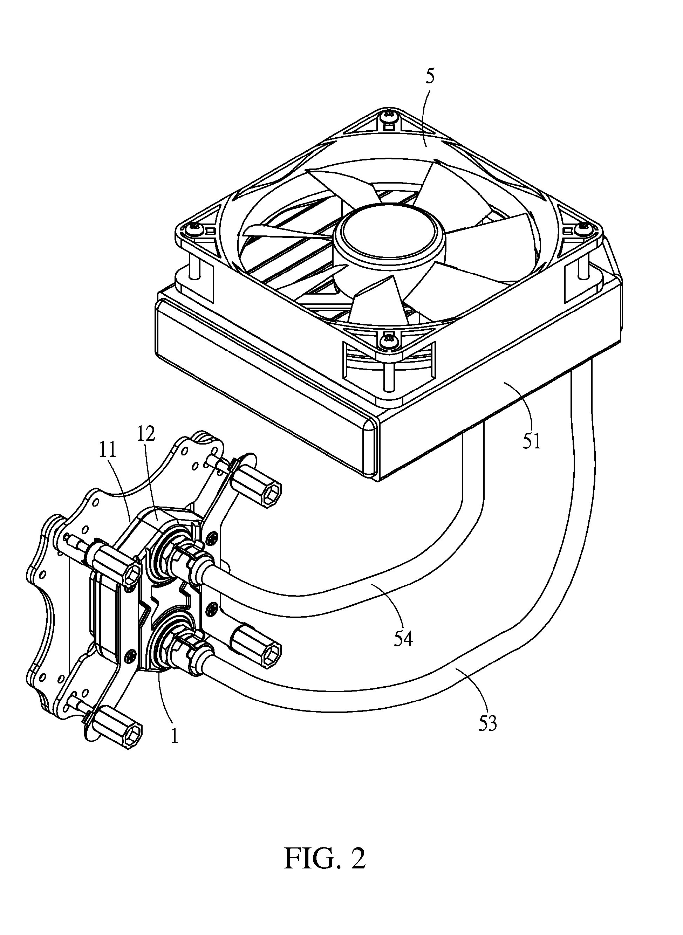

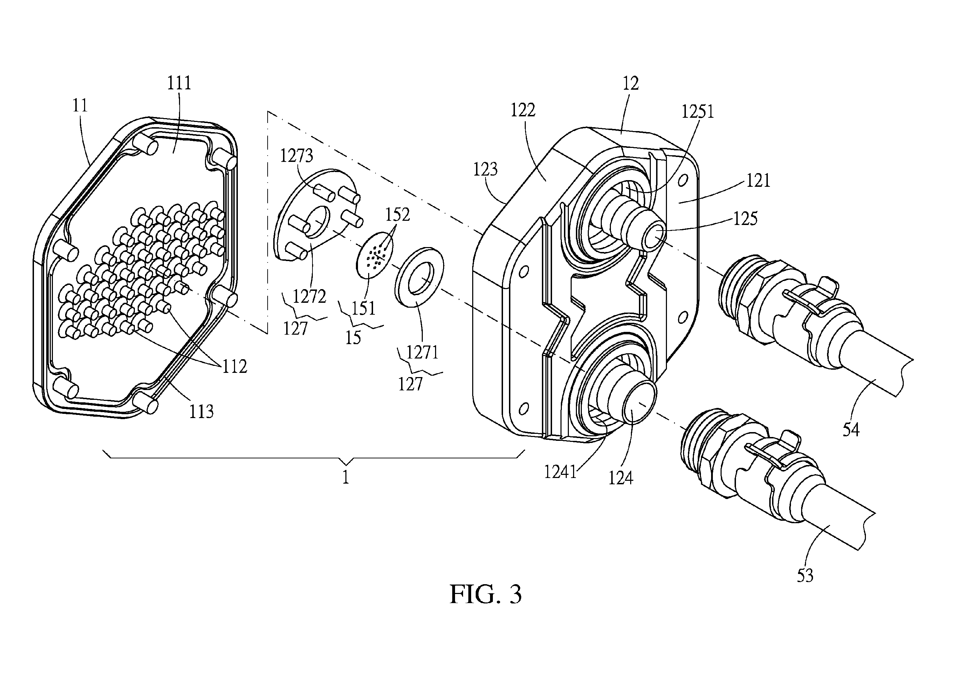

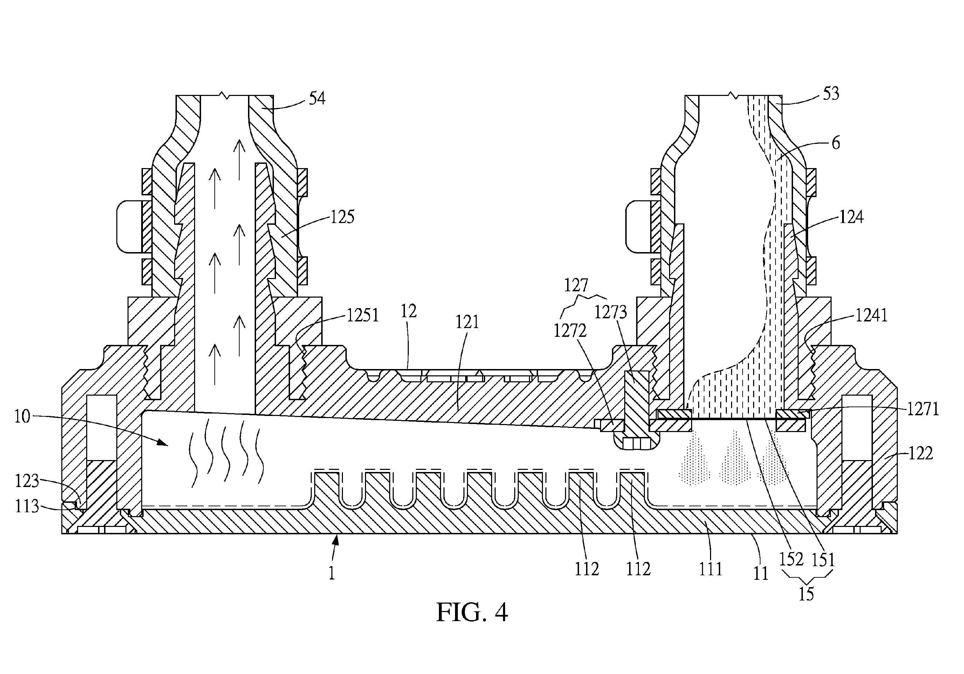

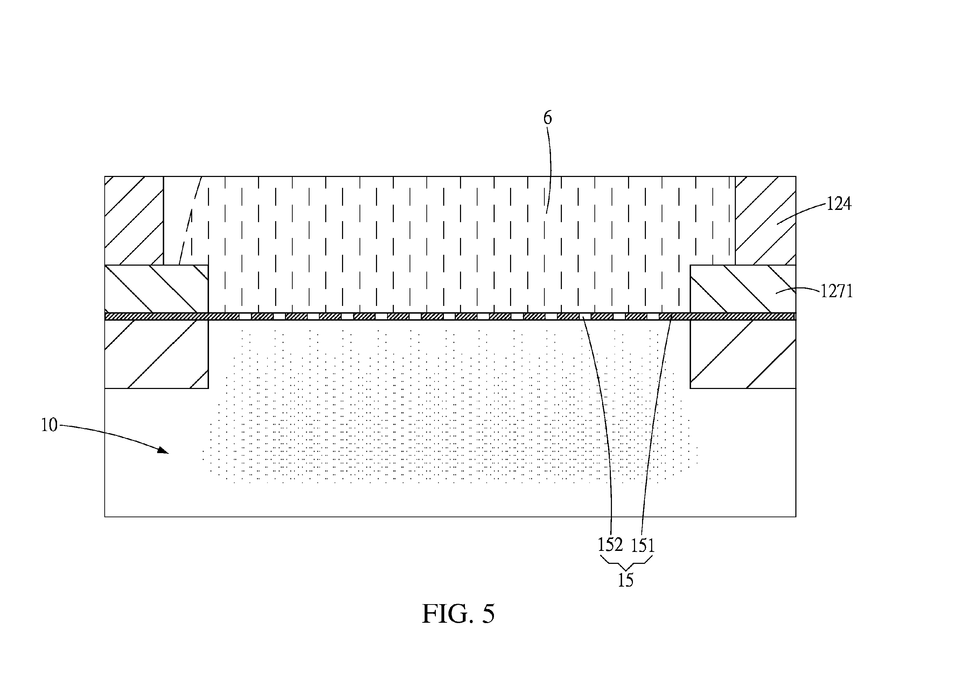

FIGS. 1-5 are a constructional schematic view, a perspective view, a partial exploded view, a partial lateral view and a partial enlarged view of the volumetric phase transfer heat dissipating system of a first embodiment of the present invention respectively.

The volumetric phase transfer heat dissipating system of the first embodiment of the present invention includes a volumetric phase transfer heat dissipating device 1 and a condenser 5. In this embodiment, the volumetric phase transfer heat dissipating device 1 is connected to the condenser 5 for operation. The condenser 5 includes a condenser body 51, a fluid transmission tube 53 and a vapor transmission tube 54. One end of the fluid transmission tube 53 and one end of the vapor transmission tube 54 are connected to the condenser body 51.

The phase transfer heat dissipating device 1 includes a base 11, a cap 12 and an atomizing member 15.

The base 11 has a base body 111 which is approximately formed as a polygonal plate. One side of the base body 111 is contacted with a heat source 8 (for example: a LED chip or a CPU). A plurality of conducting members 112 is disposed on a central region of the other side of the base body 111. A first combining portion 113 formed as stair shaped is disposed on a periphery of the base body 111. Here, the shape of the base body 111 and the shape of the first combining portion 113 described above are only examples, but embodiments of the present invention are not limited thereto. In addition, in this embodiment, the conducting members 112 are formed as rod-shaped structures, but embodiments of the present invention are not limited thereto. In some embodiments, the conducting members 112 are formed as groove-shaped structures or other non-planar surface shaped structures which can increase the surface area of the base 11 so as to increase the heat exchange area and enhance the condensing performance.

The cap 12 has a cap body 121 which is approximately formed as a polygonal plate. The cap body 121 has a supporting wall 122 extended from a periphery thereof. An end portion of the supporting wall 122 has a second combining portion 123. The shape of the second combining portion 123 corresponds to the shape of the first combining portion 113, so that the second combining portion 123 is engaged with the first combining portion 113 and the base 11 is combined with the cap 12 so as to form a chamber 10. In this embodiment, what is required is that the base 11 and the cap 12 are capable of forming a hollow structure, the structures of the base 11 and the cap 12 described above are only examples, the present invention is not limited thereto. When the conducting members 112 are rod structures, the conducting members 112 are disposed in the chamber 10 and extended toward the cap 12.

Here, the cap 12 has an inlet connecting portion 124 and an outlet connecting portion 125. The fluid transmission tube 53 is connected to the inlet connecting portion 124 and the vapor transmission tube 54 is connected to the outlet connecting portion 125, so that the working fluid 6 in the fluid transmission tube 53 is capable of flowing into the chamber 10, and the vapor of the working fluid 6 in the chamber 10 is capable of flowing out via the vapor transmission tube 54. Further, the inlet connecting portion 124 has an inlet threading portion 1241 for threading with the fluid transmission tube 53, and the outlet connecting portion 125 has an outlet threading portion 1251 for threading with the vapor transmission tube 54. In this embodiment, the chamber 10 gradually expands from one end thereof which is adjacent to the inlet connecting portion 124 toward the other end thereof which is adjacent to the outlet connecting portion 125; namely, the upper wall of the chamber 10 is inclined, resulting in that the chamber 10 gradually expands from one end thereof which is adjacent to the inlet connecting portion 124 toward the other end thereof which is adjacent to the outlet connecting portion 125.

Additionally, the conducting members 112 are disposed corresponding to the cap body 121 but are not directly disposed toward the inlet connecting portion 124 and the outlet connecting portion 125. That is to say, the conducting members 112 correspond to regions between the inlet connecting portion 124 and the outlet connecting portion 125.

The atomizing member 15 is plate structure and is disposed in the inlet connecting portion 124. The atomizing member 15 has a main body 151 and a plurality of micro-pores 152. The micro-pores 152 are disposed on the main body 151, so that the working fluid 6 in the fluid transmission tube 53 is atomized via the atomizing member 15 so as to enhance the heat dissipating performance. Here, the pore diameters of the micro-pores 152 are defined between 5 micrometers to 1000 micrometers, preferably defined between 20 micrometers to 300 micrometers. Further, the distance between any two neighboring micro-pores 152 is defined between 5 micrometers to 2000 micrometers.

In this embodiment, the inlet connecting portion 124 has a sleeving unit 127 assembled thereon and provided for sleeving the atomizing member 15. The sleeving unit 127 further includes an upper sleeving member 1271 and a lower sleeving member 1272. The upper sleeving member 1271 and the lower sleeving member 1272 are hollow shaped, and the atomizing member 15 is disposed between the upper sleeving member 1271 and the lower sleeving member 1272. Here, the upper sleeving member 1271 is attached to the cap body 121, and the atomizing member 15 is sandwiched between the upper sleeving member 1271 and the lower sleeving member 1272; in addition, the lower sleeving member 1272 is fastened on the cap body 121 via a plurality of fastening members 1273.

In some implementation aspects, the atomizing member 15 is disposed in the inlet connecting portion 124 and attached to one end of the fluid transmission tube 53, so that the working fluid 6 in the fluid transmission tube 53 is atomized via the atomizing member 15.

In the present invention, the manufacturing method of the atomizing member 15 includes following steps. At first, by physical vapor deposition, chemical vapor deposition or other technologies like LIGA (Lithographie GalVanoformung Abformung), a deposited metal layer is formed on the surface of a substrate in which the substrate is made of glass or silicon. Next, a photo resist layer is formed by spin coating method or by immersion method; in this way the photo resist layer is exposed through a mask by photolithography, and is developed to remove the photo resist layer under the unexposed region so as to reveal the ready-to-remove deposited metal layer. Subsequently, the deposited metal layer which is not protected by the photo resist layer is removed by etching, and the remainder of the photo resist layer is removed; at this time, the deposited metal layer with a plurality of through holes is formed on the surface of the substrate, the through holes are substantially the predetermined holes of the micro-pores 152 of the atomizing member 15, and the diameter of the through holes is larger than that of the micro-pores 152. Thereafter, an electrocasting metal layer is formed on the surface of the deposited metal layer by electrocasting method. Finally, a demoulding process is applied, so that the electrocasting metal layer is separated from the deposited metal layer and the substrate so as to form the atomizing member 15.

Upon operating the present invention, the working fluid 6 in the fluid transmission tube 53 is flowing to the atomizing member 15 and forms a plurality of tiny liquid drops or moistures. After flowing to the chamber 10, the tiny liquid drops or moistures become liquid which is disposed on the inner walls of the chamber 10 and the outer walls of the conducting members 112, and because of absorbing the heat from the heat source 8, the liquid is vaporized and converted to vapors which are flowing to the condenser body 51 via the vapor transmission tube 54. Thereafter, the vapors are condensed in the condenser body 51 so as to form the working fluid 6, and the working fluid 6 is flows again into the atomizing member 15 via the fluid transmission tube 53 and further flows into the chamber 10. Under such conditions, a circulating system is formed without pumps or other driving devices. Additionally, since the chamber 10 gradually expands from one end thereof which is adjacent to the inlet connecting portion 124 toward the other end thereof which is adjacent to the outlet connecting portion 125, the atomized working fluid and the vapors are prone to flow toward the outlet connecting portion 125.

In the present invention, the atomizing member 15 is disposed in the inlet connecting portion 124 of the cap 12, so that the working fluid 6 is flowing into the chamber 10 to form the liquid. Further, the liquid is disposed on the inner walls of the chamber 10 and the outer walls of the conducting members 112 for heat absorption. The conducting members 112 are disposed in the chamber 10 so as to increase the contact area between the conducting members 112 and the liquid to enhance the heat dissipating performance. Additionally, without applying pumps or other driving devices, the present invention provides an automatically circulated condensing system which has advantages such as a simplified structure, high heat dissipating performance, etc.

While the present invention has been described by the way of example and in terms of the preferred embodiments, it is to be understood that the invention need not be limited to the disclosed embodiments. On the contrary, it is intended to cover various modifications and similar arrangements included within the spirit and scope of the appended claims, the scope of which should be accorded the broadest interpretation so as to encompass all such modifications and similar structures.

## Claims

1. A volumetric phase transfer heat dissipating device (1), comprising:
a base (11), comprising a plurality of conducting members (112);
a cap (12), engaged with the base (11) so as to form a chamber (10) with the base (11), the conducting members (112) being disposed in the chamber (10), the cap (12) comprising an inlet connecting portion (124) for being connected to a fluid transmission tube (53) and comprising an outlet connecting portion (125) for being connected to a vapor transmission tube (54); and
an atomizing member (15), being sleeved to the inlet connecting portion (124) and disposed between the fluid transmission tube (53) and the chamber (10);
wherein a working fluid (6) in the fluid transmission tube (53) flows into the chamber (10) via the atomizing member (15) and liquid is formed on inner walls of the chamber (10) and outer walls of the conducting members (112), the liquid is vaporized after absorbing heat and flows out via the vapor transmission tube (54).

2. The volumetric phase transfer heat dissipating device (10) according to claim 1, wherein the base (11) further comprises a first combining portion (113), and the cap (12) further comprises a second combining portion (123), the second combining portion (123) is engaged with the first combining portion (113) so as to combine the base (11) with the cap (12).

3. The volumetric phase transfer heat dissipating device (1) according to claim 1, wherein the chamber (10) gradually expands from one end thereof which is adjacent to the inlet connecting portion (124) toward the other end thereof which is adjacent to the outlet connecting portion (125).

4. The volumetric phase transfer heat dissipating device (1) according to claim 1, wherein the inlet connecting portion (124) comprises an inlet threading portion (1241) for threading with the fluid transmission tube (53), the outlet connecting portion (125) comprises an outlet threading portion (1251) for threading with the vapor transmission tube (54).

5. The volumetric phase transfer heat dissipating device (1) according to claim 1, wherein the inlet connecting portion (124) comprises a sleeving unit (127) for sleeving the atomizing member (15).

6. The volumetric phase transfer heat dissipating device (1) according to claim 5, wherein the sleeving unit (127) comprises an upper sleeving member (1271) and a lower sleeving member (1272), the atomizing member (15) is disposed between the upper sleeving member (1271) and the lower sleeving member (1272).

7. The volumetric phase transfer heat dissipating device (1) according to claim 1, wherein the atomizing member (15) is attached to one end of the fluid transmission tube (53).

8. The volumetric phase transfer heat dissipating device (1) according to claim 1, wherein the atomizing member (15) comprises a main body (151) and a plurality of micro-pores (152) disposed on the main body (151).

9. A volumetric phase transfer heat dissipating system, comprising:
a condenser (5), comprising a condenser body (51), a fluid transmission tube (53) and a vapor transmission tube (54), one end of the fluid transmission tube (53) and one end of the vapor transmission tube (54) being connected to the condenser body (51); and
a volumetric phase transfer heat dissipating device (1), comprising:
a base (11), comprising a plurality of conducting members (112);
a cap (12), engaged with the base (11) so as to form a chamber (10) with the base (11), the conducting members (112) being disposed in the chamber (10), the cap (12) comprising an inlet connecting portion (124) for being connected to the fluid transmission tube (53) and comprising an outlet connecting portion (125) for being connected to the vapor transmission tube (54); and
an atomizing member (15), being sleeved to the inlet connecting portion (124) and disposed between the fluid transmission tube (53) and the chamber (10);
wherein the fluid transmission tube (53) is connected to the inlet connecting portion (124) of the volumetric phase transfer heat dissipating device (1), the vapor transmission tube (54) is connected to the outlet connecting portion (125) of the volumetric phase transfer heat dissipating device (1), a working fluid (6) in the fluid transmission tube (53) flows into the chamber (10) via the atomizing member (15), the liquid is formed on the inner walls of the chamber (10) and outer walls of the conducting members (112), and the liquid is vaporized after absorbing heat and flows to the condenser body (51) via the vapor transmission tube (54).

10. The volumetric phase transfer heat dissipating system according to claim 9, wherein the base (11) further comprises a first combining portion (113), and the cap (12) further comprises a second combining portion (123), the second combining portion (123) is engaged with the first combining portion (113) so as to combine the base (11) with the cap (12).

11. The volumetric phase transfer heat dissipating system according to claim 9, wherein the chamber (10) gradually expands from one end thereof which is adjacent to the inlet connecting portion (124) toward the other end thereof which is adjacent to the outlet connecting portion (125).

12. The volumetric phase transfer heat dissipating system according to claim 9, wherein the inlet connecting portion (124) comprises an inlet threading portion (1241) for threading with the fluid transmission tube (53), the outlet connecting portion (125) comprises an outlet threading portion (1251) for threading with the vapor transmission tube (54).

13. The volumetric phase transfer heat dissipating system according to claim 9, wherein the inlet connecting portion (124) comprises a sleeving unit (127) for sleeving the atomizing member (15).

14. The volumetric phase transfer heat dissipating system according to claim 13, wherein the sleeving unit (127) comprises an upper sleeving member (1271) and a lower sleeving member (1272), the atomizing member (15) is disposed between the upper sleeving member (1271) and the lower sleeving member (1272).

15. The volumetric phase transfer heat dissipating system according to claim 9, wherein the atomizing member (15) is attached to one end of the fluid transmission tube (53).
